**Europäisches Patentamt**

**European Patent Office**

**Office européen des brevets**

(19)

(11) Veröffentlichungsnummer : **0 551 293 B1**

(12) **EUROPÄISCHE PATENTSCHRIFT**

(45) Veröffentlichungstag der Patentschrift :
**14.06.95 Patentblatt 95/24**

(51) Int. Cl.$^6$ : **H03G 11/00**

(21) Anmeldenummer : **91915935.0**

(22) Anmeldetag : **21.09.91**

(86) Internationale Anmeldenummer :
**PCT/DE91/00751**

(87) Internationale Veröffentlichungsnummer :
**WO 92/06536 16.04.92 Gazette 92/09**

(54) **SPANNUNGSBEGRENZUNG FÜR EINE TRANSISTORSCHALTUNG.**

(30) Priorität : **04.10.90 DE 4031350**

(43) Veröffentlichungstag der Anmeldung :
**21.07.93 Patentblatt 93/29**

(45) Bekanntmachung des Hinweises auf die
Patenterteilung :
**14.06.95 Patentblatt 95/24**

(84) Benannte Vertragsstaaten :
**DE FR GB IT**

(56) Entgegenhaltungen :
**EP-A- 0 050 900
CH-A- 452 666
DE-A- 3 227 536
US-A- 4 495 537**

(73) Patentinhaber : **ROBERT BOSCH GMBH
Postfach 30 02 20
D-70442 Stuttgart (DE)**

(72) Erfinder : **MICHEL, Hartmut
Herderstrasse 74
D-7410 Rautlingen (DE)**
Erfinder : **NELLE, Ulrich
Lindenstrasse 25
D-7419 Sonnenbuehl 1 (DE)**
Erfinder : **MINDL, Anton
Beckmannweg 19/1
D-7400 Tuebingen (DE)**
Erfinder : **BIRECKOVEN, Bernd
Hölderlinstrasse 19
D-7408 Kusterdingen (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

### Stand der Technik

Die Erfindung betrifft eine Spannungsbegrenzung für eine Transistorschaltung nach dem Oberbegriff des Anspruchs 1.

Eine bekannte Spannungsbegrenzung bei einer integrierten Schaltung (DE 32 27 536 Al) verwendet eine gesteuerte Deck-("Gate")-Elektrode. Die dort beschriebene, spannungsgesteuerte Kollektorspannungsbegrenzung entspricht einer im Prinzip durchschlagsgefährdeten MOS-Struktur. Die Temperaturkompensation ist gegebenenfalls nicht ausreichend und zudem sind zusätzliche Prozeßschritte im Wafer-Prozeß erforderlich.

Aus der CH-A 452 666 ist bereits eine Schaltung zur Begrenzung hoher Gleichspannungen bekannt, bei der eine Zenerdiode vor der Basis eines weiteren Transistors angeordnet ist Eine weiter allgemein bekannte Spannungsbegrenzung bei hochsperrenden Transistoren wird häufig dadurch ausgeführt, daß ein Referenzelement in Form einer Zener-Diode mit der einen Seite an die Basis des Transistors angeschlossen ist. Mit der anderen Seite liegt sie am Mittenabgriff eines Spannungsteilers, dessen einer Fußpunkt am Emitter des Transistors liegt und dessen anderer Fußpunkt mit dem Kollektor des Transistors verbunden ist. Die Bestandteile einer solchen Schaltung können diskret aufgebaut oder monolithisch integriert sein.

Eine solche Anordnung besitzt bei einem hochverstärkenden Transistor (Darlington) eine ausgeprägte Schwingneigung der Begrenzungsspannung, insbesondere wenn zwischen Kollektor und Emitter des Transistors zusätzliche Kapazitäten vorhanden sind.

Wenn der Transistor als zweistufiger Darlington ausgeführt ist, läßt sich die Schwingneigung durch eine Beschaltung durch einen Kondensator oder eine Widerstand-Kondensator-Anordnung am Spannungsteiler eliminieren. Diese Maßnahme greift nicht mehr, wenn der Spannungsteiler hochohmiger sein soll, so daß der Transistor als dreistufiger Darlington-Transistor ausgebildet sein muß. Zudem ist eine solche Zusatzbeschaltung wegen der erforderlichen Größe der Kapazität praktisch nicht integrierbar.

### Vorteile der Erfindung

Der Erfindung liegt die Aufgabe zugrunde, eine Transistorendstufe mit einer Spannungsbegrenzungseinrichtung bzw. eine Spannungsbegrenzungseinrichtung anzugeben, bei der mit einfachen Mitteln die Schwingungsneigung gering gehalten wird.

Diese Aufgabe wird durch die Erfindung, wie sie durch Ansprüche 1 und 10 definiert ist, gelöst.

Erfindungsgemäß kann das Referenzelement zur Reduzierung der Schwingneigung hinter dem Ansteuerkreis der ersten Stufe oder noch dichter am Ausgang der Spannungsbegrenzerschaltung angeordnet, werden. Es hat sich nämlich herausgestellt, daß für die Schwingneigung eines Aufbaus mit Referenzelement nicht die Anzahl der Verstärkerstufen maßgebend ist, über die der am Spannungsteilerpunkt entnommene Strom fließt, sondern die Position des Referenzelements in der Kette. Je dichter das Referenzelement in Form einer Zener-Diode am Ausgang sitzt, desto geringer ist die Schwingneigung.

Wird z.B. bei einer dreistufigen Anordnung das Referenzelement in die Basisleitung des Endstufentransistors eingefügt, so ist auch bei einem vorgeschalteten, zweistufigen Darlington-Verstärker die Schwingneigung beseitigt. Der erhöhte Strom durch das Referenzelement ist auch bei einer integrierten Struktur problemlos.

Eine Spannungsbegrenzung ist ohne durchschlagsgefährdete MOS-Strukturen bei besserer Temperaturkompensation und weniger Prozeßschritten im Wafer-Prozeß möglich.

### Zeichnung

Anhand einer Zeichnung wird die Erfindung näher erläutert.
Es zeigen:

| | |
|---|---|
| Fig. 1 | eine bekannte Schaltung zur Spannungsbegrenzung für den Ausgang einer Transistorschaltung zur Erläuterung des Standes der Technik, |
| Fig. 2a | eine erste Ausführungsform einer erfindungsgemäßen Spannungsbegrenzung mit NPN-Transistoren, |
| Fig. 2b | eine Ausführungsform entsprechend der Fig. 2a mit PNP-Transistoren, |
| Fig. 2c | eine Ausführungsform nach Fig. 2b mit einer Flankenformerschaltung, |
| Fig. 2d | eine Ausführungsform entsprechend Fig. 2a mit einer Flankenformerschaltung, |
| Fig. 3a | eine zweite Ausführungsform einer erfindungsgemäßen Spannungsbegrenzung, |

Fig. 3b      eine dritte Ausführungsform einer erfindungsgemäßen Spannungsbegrenzung,

Fig. 4      eine erste Schaltungsvariante als eigenständiges Begrenzerelement,

Fig. 5      eine zweite Schaltungsvariante als eigenständiges Begrenzerelement,

Fig. 6      eine weitere Ausführungsform der erfindungsgemäßen Spannungsbegrenzung mit einer Stromspiegelschaltung.

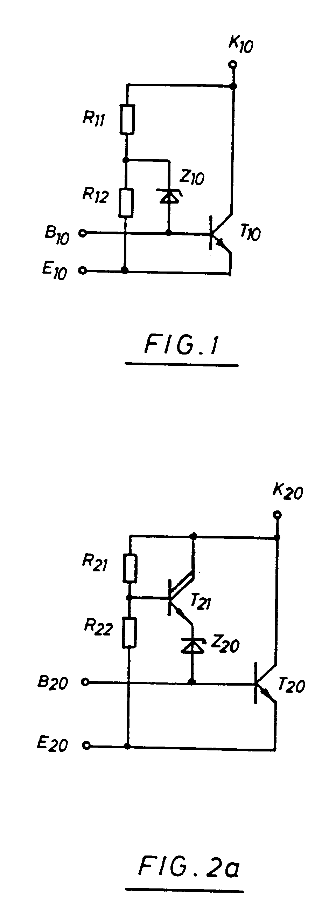

In der bekannten Schaltungsanordnung nach Fig. 1 ist eine Spannungsbegrenzung für einen hochsperrenden Transistor $T_{10}$ gezeigt, mit einem Referenzelement als Zener-Diode $Z_{10}$, die mit der einen Seite an der Basis $B_{10}$ des Transistors $T_{10}$ angeschlossen ist. Mit der anderen Seite ist sie am Mittenabgriff eines aus Widerständen $R_{11}$ und $R_{12}$ bestehenden Spannungsteilers $R_{11}/R_{12}$ angeschlossen. Der eine Fußpunkt des Spannungsteilers $R_{11}/R_{12}$ ist mit dem Emitter $E_{10}$ des Transistors $T_{10}$ und der andere Fußpunkt mit dem Kollektor $K_{10}$ verbunden.

Die Begrenzung der Kollektorspannung erfolgt hier bei:

$$U_{KE} = (U_Z + U_{BE}) \cdot (1 + R_{11}/R_{12}).$$

Durch geeignete Wahl der Widerstände $R_{11}$ und $R_{12}$ ist ein relativ kleiner Wert von $U_Z$ (Zener-Spannung) in einen hohen Wert von $U_{KE}$ umzusetzen.

Durch Änderung des Teilerverhältnisses (Funktionsabgleich) ist eine genaue Einstellung der Spannungsbegrenzung auf verschiedene Werte möglich.

Die Schaltung funktioniert unter der Voraussetzung in der dargestellten Weise, daß der über die Zener-Diode fließende Basisstrom zum Transistor $T_{10}$ klein gegen den Teilerstrom durch die Widerstände $R_{11}$ und $R_{12}$ ist. Dies ist häufig nur möglich, wenn als Transistor $T_{10}$ ein zwei- oder dreistufiger Darlington-Transistor eingesetzt wird.

Eine solche mehrstufige Anordnung besitzt unter anderem wegen der hohen Kreisverstärkung eine ausgeprägte Schwingneigung der Begrenzungsspannung, besonders wenn zwischen Kollektor $K_{10}$ und Emitter $E_{10}$ zusätzliche Kapazitäten vorhanden sind.

Es ist bekannt, diese Schwingneigung durch eine C- oder RC-Beschaltung über den Widerstand $R_{11}$ zu eliminieren, wenn der Transistor $T_{10}$ ein zweistufiger Darlington-Transistor ist.

Bei einem hochohmigen Spannungsteiler mit einem dann erforderlichen dreistufigen Darlington-Transistor läßt sich diese Anordnung mit der dargestellten Zusatzbeschaltung nicht entschwingen. Wegen der erforderlichen Größe der Kapazität C läßt sich außerdem eine Zusatzbeschaltung praktisch nicht integrieren.

In den nachfolgenden Fig. sind erfindungsgemäße Schaltungen wiedergegeben, bei denen eine solche Schwingneigung eliminiert ist und eine gute Temperaturkompensation möglich ist. Zudem können die nachfolgenden Schaltungen gut integriert werden.

In der erfindungsgemäßen Schaltung nach Fig. 2a hat der Kollektor $K_{20}$ und der Emitter $E_{20}$ eines Endstufentransistors $T_{20}$ jeweils Verbindung mit den äußeren Anschlüssen eines aus Widerständen $R_{21}$ und $R_{22}$ bestehenden Spannungsteilers $R_{21}/R_{22}$. Der Mittenabgriff des Spannungsteilers $R_{21}/R_{22}$ hat Verbindung mit der Basis eines zweistufigen Darlington-Verstärkers $T_{21}$. Dessen Kollektor ist mit dem Kollektor $K_{20}$ des Endstufentransistors $T_{20}$ und der Emitter mit der Basis $B_{20}$ des Endstufentransistors $T_{20}$ über eine Zener-Diode $Z_{20}$ verbunden.

Die Spannungsbegrenzung erfolgt hier bei:

$$U_{KE} = (U_Z + 3U_{BE}) \cdot (1 + R_{21}/R_{22}).$$

Wenn als Referenzelement eine Zener-Diode mit Avalanche-Effekt verwendet wird, so hat diese einen positiven Gang der Durchbruchspannung über der Temperatur. Durch das Hinzufügen von $3U_{BE}$ zu $U_Z$ kann der Temperaturgang zum Teil kompensiert werden. Durch schaltungstechnische Maßnahmen kann aber auch volle Kompensation oder, falls gewünscht, Überkompensation erreicht werden.

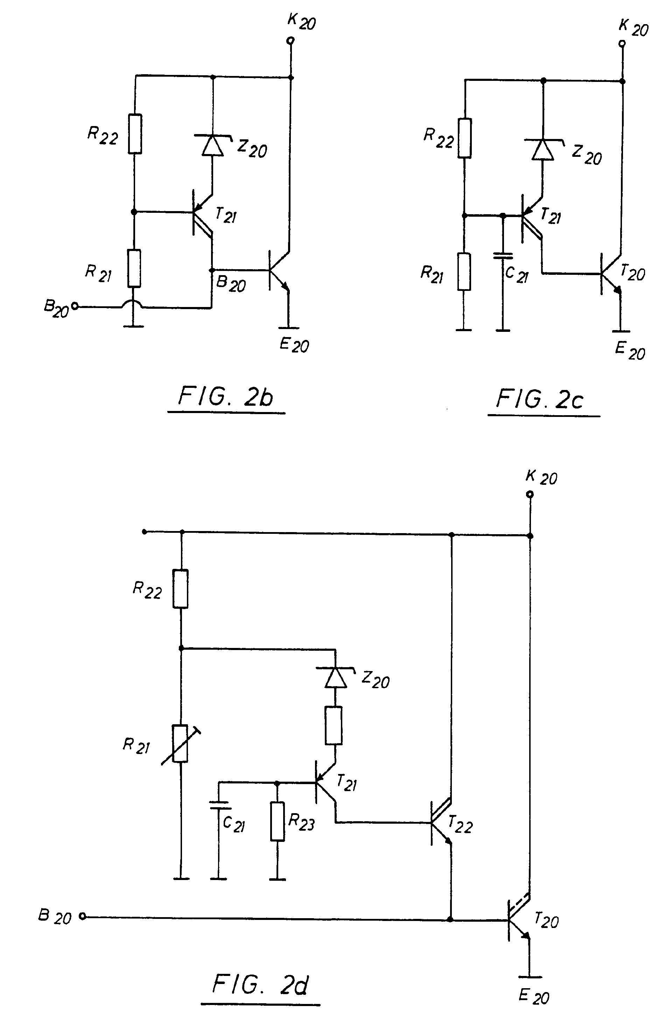

In Fig. 2b ist eine entsprechende Spannungsbegrenzerschaltung mit PNP-Transistoren dargestellt, wogegen die Schaltung in Fig. 2a mit NPN-Transistoren aufgebaut ist.

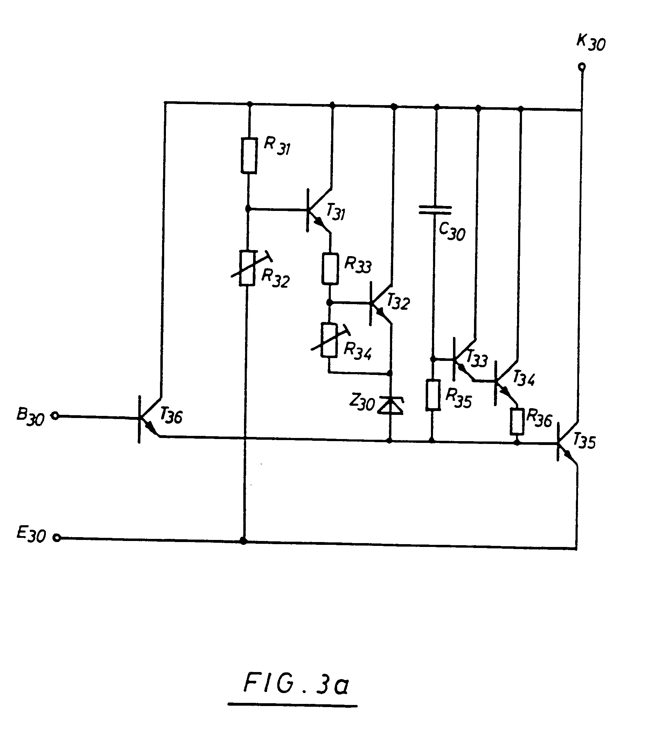

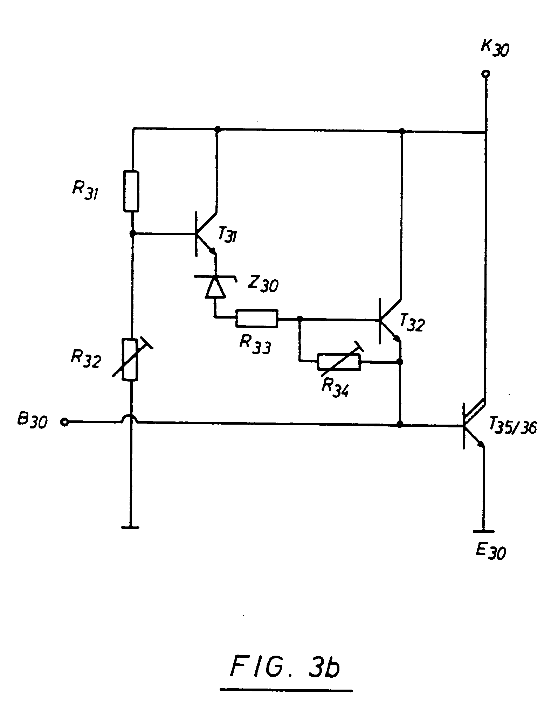

Bei einem sehr raschen Abschalten einer Induktivität kann die Spannung unter Umständen so schnell ansteigen, daß es beim Eintritt in die Spannungsbegrenzung zu einem unerwünschten Überschießen kommt. Durch Einsatz eines integrierten Flankenformers kann auch dieser Störeffekt beseitigt werden. Er kann prinzipiell an die Basis jedes Transistors in der Spannungsbegrenzerschaltung, der vor dem Zenerelement liegt, angebunden werden. Solche Flankenformer sind in den Schaltungen nach den Fig. 2b, 2c und den Fig. 3 dargestellt.

Die Spannungsbegrenzerschaltung läßt sich auch mit PNP-Transistoren darstellen, vergleiche Fig. 2b, 2c, 2d. In Fig. 2c ist die Flankenformerschaltung als Kapazität an der Basis des ersten Transistors $T_{21}$ ausgebildet. In Fig. 2d ist eine weitere Ausführungsform mit Flankenformerschaltung gezeigt, wobei $C_{21}$ als Kapazität oder als vollständige Flankenformerschaltung, in der gezeichneten Ausführung mit einem PNP-Transistor, ausgeführt sein kann. Die Endstufe $T_{20}$ kann als Darlington- oder als Einfachtransistor ausgeführt sein.

Besonders vorteilhaft ist die Ausführung 2d, da die Flankenformerschaltung hier nicht gegen den Kollektor

$K_{20}$ spannungsfest sein muß und das Konzept somit leichter integrierbar ist.

Eine vollständige, integrierbare Anordnung ist in Fig. 3 dargestellt. Der Kollektor $K_{30}$ und der Emitter $E_{30}$ eines Endstufentransistors $T_{35}$ haben jeweils Verbindung mit den äußeren Anschlüssen eines aus Widerständen $R_{31}$ und $R_{32}$ bestehenden Spannungsteilers $R_{31}/R_{32}$.

Der Kollektor $K_{30}$ des Endstufentransistors $T_{35}$ ist mit dem Kollektor eines Transistors $T_{36}$ verbunden, dessen Basis der Basis $B_{30}$ der Anordnung entspricht und dessen Emitter mit der Basis des Endstufentransistors $T_{35}$ verbunden ist.

Der Mittenabgriff des Spannungsteilers $R_{31}/R_{32}$ hat Verbindung mit der Basis eines Transistors $T_{31}$, dessen Kollektor mit dem Kollektor $K_{30}$ den Endstufentransistors $T_{35}$ und dessen Emitter mit dem äußeren Anschluß eines weiteren, aus Widerständen $R_{33}$ und $R_{34}$ bestehenden Spannungsteilers $R_{33}/R_{34}$ verbunden ist.

Der Mittenabgriff des Spannungsteilers $R_{33}/R_{34}$ hat Verbindung mit der Basis eines Transistors $T_{32}$, dessen Kollektor mit dem Kollektor $K_{30}$ des Endstufentransistors $T_{35}$ und dessen Emitter mit dem anderen, äußeren Anschluß des Spannungsteilers $R_{33}/R_{34}$ und über eine Zener-Diode $Z_{30}$ mit der Basis des Endstufentransistors $T_{35}$ verbunden ist. Die Widerstände $R_{32}$ und $R_{34}$ sind einstellbar. Die Zenerdiode $Z_{30}$ kann auch als Serienschaltung eines Widerstandes und einer Zenerdiode ausgeführt sein.

Zwischen der Basis und dem Kollektor $K_{30}$ des Endstufentransistors $T_{35}$ liegt ein Widerstand $R_{35}$ mit nachgeschaltetem Kondensator $C_{30}$.

Der Mittenanschluß zwischen dem Widerstand $R_{35}$ und dem Kondensator $C_{30}$ hat Verbindung mit der Basis eines Transistors $T_{33}$, dessen Kollektor mit dem Kollektor $K_{30}$ des Endstufentransistors $T_{35}$ und dessen Emitter mit der Basis eines weiteren Transistors $T_{34}$ verbunden ist.

Der Kollektor des Transistors $T_{34}$ hat Verbindung mit dem Kollektor $K_{30}$ des Endstufentransistors $T_{35}$ und der Emitter über einen Widerstand $R_{36}$ mit der Basis des Endstufentransistors $T_{35}$.

Im Vergleich zur Schaltungsanordnung nach Fig. 2 ist anstelle des Darlington-Verstärkers $T_{21}$ für eine präzise Einstellung des Temperaturgangs die Anordnung aus den Transistoren $T_{31}$ und $T_{32}$ sowie der Widerstände $R_{33}$ und $R_{34}$ getreten.

Die Spannungsbegrenzung erfolgt hier bei:
$$U_{KE} = (U_Z + (3 + R_{33}/R_{34}) \cdot U_{BE}) \cdot (1 + R_{31}/R_{32}).$$

Der Temperaturgang kann zunächst am Spannungsteiler $R_{33}/R_{34}$ eingestellt werden; die Begrenzungsspannung anschließend am Spannungsteiler $R_{31}/R_{32}$.

Der Flankenformer besteht hier aus den Transistoren $T_{33}$ und $T_{34}$ sowie den Widerständen $R_{35}$ und $R_{36}$ sowie der Kapazität $C_{30}$.

Der positive Verschiebungsstrom durch die (integrierte) Basis-Kollektor-Kapazität $C_{30}$ wird über die Transistoren $T_{33}$ und $T_{34}$ verstärkt und reduziert somit die Spannungsanstiegsgeschwindigkeit am Endstufentransistor $T_{35}$. Die Gegenkopplung über die Widerstände $R_{35}$ und $R_{36}$ dient der genauen Einstellung der Stromverstärkung der Transistoren $T_{33}$ und $T_{34}$.

Bei normalem Vorwärtsbetrieb wird der Transistor $T_{35}$ über den Transistor $T_{36}$ eingeschaltet, was zu einer gewünschten Entkopplung von Basis- und Klammerkreis führt.

Der Transistor $T_{36}$ kann auch als Zweifach-Darlington oder als Emitterfolger mit getrenntem Kollektor ausgeführt werden.

Die Funktion der Flankenformerschaltung, wenn sie zwischen dem Kollektor $K_{30}$ und der Basis eines anderen Transistors in der Spannungsbegrenzerschaltung, z.B. $T_{32}$ entsprechend Fig. 3b, angeordnet ist, erklärt sich analog.

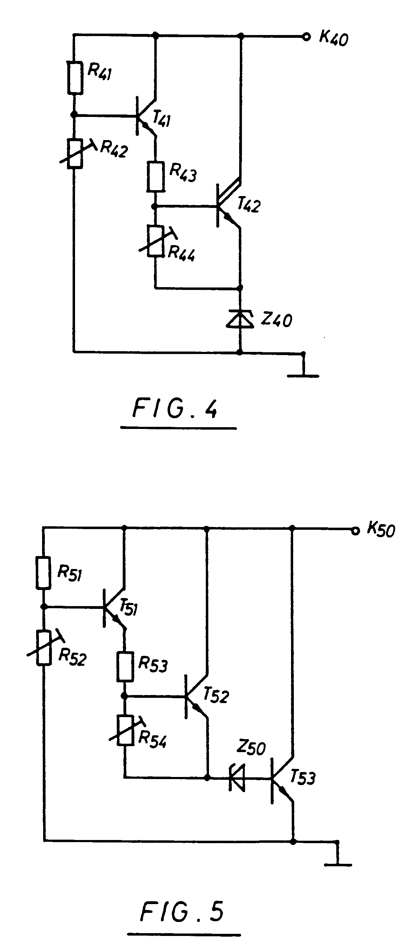

In Fig. 4 ist in der Emitterleitung eines Zweifach-Darlington-Verstärkers $T_{42}$ zu Masse hin eine Zener-Diode $C_{40}$ angeordnet. Parallel zu der Kollektor-Emitter-Strecke des Darlington-Verstärkers $T_{42}$ einschließlich der Zener-Diode $Z_{40}$ liegt ein aus Widerständen $R_{41}$ und $R_{42}$ gebildeter Spannungsteiler $R_{41}/R_{42}$.

Der Mittenabgriff des Spannungsteilers $R_{41}/R_{42}$ hat Verbindung mit der Basis eines Transistors $T_{41}$, dessen Kollektor mit dem Kollektor $K_{40}$ des Darlington-Verstärkers T42 und dessen Emitter mit dem äußeren Anschluß eines aus Widerständen $R_{43}$ und $R_{44}$ bestehenden Spannungsteilers $R_{43}/R_{44}$ verbunden ist.

Der Mittenabgriff des Spannungsteilers $R_{43}/R_{44}$ ist mit der Basis des Darlington-Verstärkers $T_{42}$ und der andere, äußere Anschluß des Spannungsteilers $R_{43}/R_{44}$ mit dem Emitter des Darlington-Verstärkers $T_{42}$ verbunden. Die Widerstände $R_{42}$ und $R_{44}$ sind einstellbar. Die in Fig. 4 verwendete Schaltungsvariante dient als eigenständiges Begrenzerelement.

In Fig. 5 liegt parallel zur Kollektor-Emitter-Strecke eines Ausgangstransistors $T_{53}$ ein aus Widerständen $R_{51}$ und $R_{52}$ bestehender Spannungsteiler $R_{51}/R_{52}$, wobei der Emitter mit Masse verbunden ist.

Der Mittenabgriff des Spannungsteilers $R_{51}/R_{52}$ hat Verbindung mit der Basis eines Transistors $T_{51}$, dessen Kollektor mit dem Kollektor $K_{50}$ des Ausgangstransistors $T_{53}$ und dessen Emitter mit dem äußeren Anschluß eines weiteren, aus Widerständen $R_{53}$ und $R_{54}$ bestehenden Spannungsteilers $R_{53}/R_{54}$ verbunden ist.

Der Mittenabgriff des Spannungsteilers $R_{53}/R_{54}$ hat Verbindung mit der Basis eines Transistors $T_{52}$, dessen

Kollektor mit dem Kollektor $K_{50}$ des Ausgangstransistors $T_{53}$ und dessen Emitter mit dem anderen, äußeren Anschluß des Spannungsteilers $R_{53}$/ $R_{54}$ und über eine Zener-Diode $Z_{50}$ mit der Basis des Ausgangstransistors $T_{53}$ verbunden ist. Die Widerstände $R_{52}$ und $R_{54}$ sind einstellbar.

Fig. 5 stellt eine weitere Schaltungsvariante dar, die als eigenständiges Begrenzerelement dient.

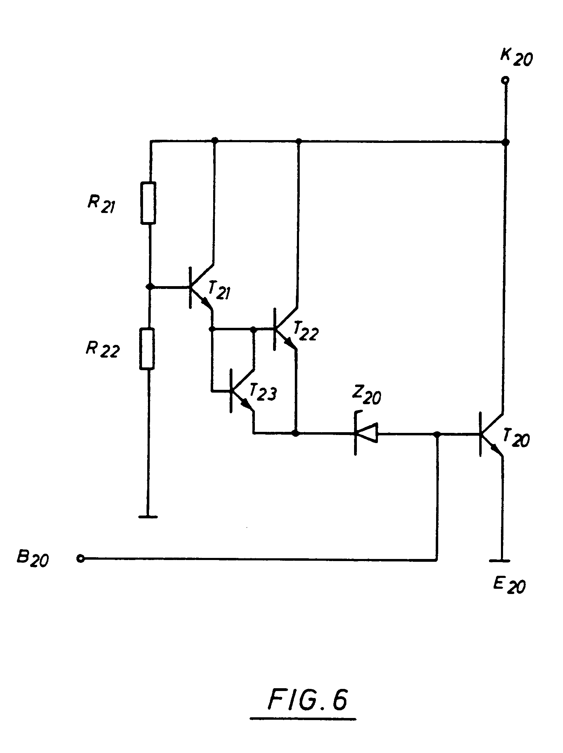

Fig. 6 zeigt eine Spannungsbegrenzerschaltung, die eine Stromspiegelschaltung zur Einstellung der Stromverstärkung enthält.

**Patentansprüche**

1. Transistor-Leistungsenstufe mit einem npn-Endstufentransistor (T20, T35) und mit einer Spannungsbegrenzungseinrichtung zur Begrenzung der Spannung am Kollektor des Endstufentransistors (T20, T35), die einen zwischen dem Kollektor und dem Emitter des Endstufentransistors (T20, T35) liegenden Spannungsteiler (R21, R22) sowie eine als Spannungsreferenzelement dienende Z-Diode (Z20, Z30) enthält, die in einem die Kollektor-Basis-Strecke des Endstufentransistors (T20, T35) überbrückenden Strompfad angeordnet ist und mit einem Abgriff des Spannungsteilers (R21, R22) in Wirkverbindung steht, dadurch gekennzeichnet, daß die Spannungsbegrenzungseinrichtung des weiteren einen Transistorverstärker (T21; T31, T32) enthält, der mit seiner Emitter-Kollektor-Strecke zur Z-Diode (Z20; Z30) in Reihe geschaltet ist.

2. Leistungsendstufe nach Anspruch 1, dadurch gekennzeichnet, daß der npn-Endstufentransistor (T 20; T35/36) ein Darlingtontransistor ist (Fig. 2d und 3b).

3. Leistungsendstufe nach Anspruch 1 oder 2, dadurch gekennzeichnet, daß der Transistorverstärker ein npn-Transistor (T21) ist, der mit seiner Basis an den Abgriff des Spannungsteilers (R21, R22), mit seinem Kollektor an den Kollektor des Enstufentransistors (T20) und mit seinem Emitter an die Kathode der Z-Diode (Z20) angeschlossen ist, die mit ihrer Anode an der Basis des Endstufentransistors (T20) liegt (Fig. 2a).

4. Leistungsendstufe nach Anrspruch 3, dadurch gekennneichnet, daß der den Transistorverstärker bildende npn-Transistor (T21) als Darlingtonverstärker ausgebildet ist (Fig. 2a und 3a).

5. Leistungsendstufe nach Anspruch 4, dadurch gekennzeichnet, daß der Darlingtonverstärker (T21) als ein aus einem Eingangstransistor (T31) und einem Ausgangstransistor (T32) bestehender zweistufiger Verstärker ausgebildet ist (Fig. 2a und 3a).

6. Leistungsendstufe nach Anspruch 5, dadurch gekennzeichnet, daß in den Emitterkreis des Eingangstransistors (T31) ein Emittervorwiderstand (R33) und zwischen die Basis und den Emitter des Ausgangstransistors (T32) ein weiterer Widerstand (R34) geschaltet ist, der zusammen mit dem Emittervorwiderstand (R33) einen weiteren Spannungsteiler (R33, R34) bildet (Fig. 3a).

7. Leistungsendstufe nacn Anspruch 1 oder 2, dadurch gekennzeichnet, daß der Transistorverstärker ein pnp-Transistor (T21) ist, der mit seiner Basis an den Abgriff des Spannungsteilers (R22, R21), mit seinem Kollektor an die Basis (B20) des Endstufentransistors und mit seinem Emitter an die Anode der Z-Diode (Z20) angeschlossen ist, die mit ihrer Kathode am Kollektor (K20) des Endstufentransistors (T20) liegt (Figuren 2b und 2c).

8. Leistungsendstufe nach Anspruch 7, dadurch gekennzeichnet, daß der den Transistorverstärker bildende pnp-Transistor (T21) als Darlingtonverstärker ausgebildet ist (Fig. 2b und 2c).

9. Leistungsendstufe nach einem der Ansprüche 1 bis 8, dadurch gekennzeichnet, daß zwischen der Basis und dem Kollektor (K30) des Endstufentransistors (T35) ein Widerstand (R35) mit nachgeschaltetem Kondensator (C30) liegt, daß der Mittenanschluß zwischen dem Widerstand (R35) und dem Kondensator (C30) Verbindung mit der Basis eines npn-Transistors (T33) hat, der mit seinem Kollektor an den Kollektor (K30) des Endstufentransistors (T35) und mit seinem Emitter an die Basis eines weiteren npn-Transistors (T34) verbunden ist, daß der Kollektor des weiteren npn-Transistors (T34) mit dem Kollektor (K30) des Endstufentransistors (T35) und der Emitter des weiteren npn-Transistors (T34) über einen Widerstand (R36) mit der Bazis des Endstufentransistors (T35) verbunden ist.

10. Spannungsbegrenzungseinrichtung zur Begrenzung der Spannung an einer ein positives Potential führenden Klemme einer Transistorschaltung mit einem zwischen der Klemme (K40; K50) und Masse liegenden Spannungsteiler (R41; R42) und einer als Spannungsreferenzelement dienenden Z-Diode (Z40; Z50), die in einem zwischen der Klemme und Masse liegenden Strompfad angeordnet ist und mit einem Abgriff des Spannungsteilers in Wirkverbindung steht, dadurch gekennzeichnet, daß die Spannungsbegrenzungseinrichtung des weiteren einen Transistorverstärker (T41, T42; T51, T52) enthält, der mit seiner Emitter-Kollektor-Strecke zur Z-Diode (Z40; Z50) in Reihe geschaltet ist.

11. Spannungsbegrenzungseinrichtung nach Anspruch 10, dadurch gekennzeichnet, daß die Anode der Z-Diode (Z50) über die Basis-Emitter-Strecke eines npn-Transistors (T53) mit Masse verbunden ist, wobei der Kollektor des Transistors (T53) an die Klemme (K50) angeschlossen ist.

12. Spannungsbegrenzungseinrichtung nach Anspruch 10 oder 11, dadurch gekennzeichnet, daß die Anode der Z-diode (Z40; Z50) mit Masse verbunden ist und daß der Transistorverstärker ein vorzugsweise als Darlington-Transistor ausgeführter npn-Transistor (T41, T42; T51, T52) ist, der mit seiner Basis an den Abgriff des Spannungsteilers (R41, R42; R51, R52), mit seinem Kollektor an die Klemme (K40; K50) und mit seinem Emitter an die Kathode der Z-Diode (Z40; Z50) angeschlossen ist (Figuren 4 und 5).

13. Spannungsbsgrenzungseinrichtung nach Anspruch 12, dadurch gekennzeichnet, daß der Darlington-Transistor (T41, T42; T51, T52) einen Eingangstransistor (T41; T51) und einen vorzugsweise als Darlington-Transistor ausgebildeten Ausgangstransistor (T42; T52) hat.

14. Spannungsbegrenzungseinrichtung nach Anspruch 13, dadurch gekennzeichnet, daß in den Emitterkreis des Eingangstransistors (T41; T51) ein Emittervorwiderstand (R43; R53) und zwischen die Basis und den Emitter des Ausgangstransistors (T42; T52) ein weiterer Widerstand (R44; R54) geschaltet ist, der zusammen mit dem Emittervorwiderstand (R43; R53) einen weiteren Spannungsteiler (R43, R44; R53, R54) bildet.

## Claims

1. Transistor power output stage having an npn output stage transistor (T20, T35) and having a voltage limiting device for limiting the voltage across the collector of the output stage transistor (T20, T35), which device contains a voltage divider (R21, R22) between the collector and the emitter of the output stage transistor (T20, T35) as well as a Z-diode (Z20, Z30), which serves as a voltage reference element, is arranged in a current path bridging the collector-base junction of the output stage transistor (T20, T35) and is operatively connected to a tap of the voltage divider (R21, R22), characterized in that the voltage limiting device additionally contains a transistor amplifier (T21; T31, T32), the emitter-collector path of which amplifier is connected in series with the Z-diode (Z20; Z30).

2. Power output stage according to Claim 1, characterized in that the npn output stage transistor (T20; T35/36) is a Darlington transistor (Figs. 2d and 3b).

3. Power output stage according to Claim 1 or 2, characterized in that the transistor amplifier is an npn transistor (T21), the base of which is connected to the tap of the voltage divider (R21, R22), the collector of which is connected to the collector of the output stage transistor (T20) and the emitter of which is connected to the cathode of the Z-diode (Z20), the anode of which diode is connected to the base of the output stage transistor (T20) (Fig. 2a).

4. Power output stage according to Claim 3, characterized in that the npn transistor (T21) forming the transistor amplifier is constructed as a Darlington amplifier (Figs. 2a and 3a).

5. Power output stage according to Claim 4, characterized in that the Darlington amplifier (T21) is constructed as a two-stage amplifier comprising an input transistor (T31) and an output transistor (T32) (Figs. 2a and 3a).

6. Power output stage according to Claim 5, characterized in that an emitter series resistor (R33) is connected in the emitter circuit of the input transistor (T31) and a further resistor (R34) is connected between the base and the emitter of the output transistor (T32) and forms, together with the emitter series resistor (R33), a further voltage divider (R33, R34) (Fig. 3a).

7. Power output stage according to Claim 1 or 2, characterized in that the transistor amplifier is a pnp transistor (T21), the base of which is connected to the tap of the voltage divider (R22, R21), the collector of which is connected to the base (B20) of the output stage transistor and the emitter of which is connected to the anode of the Z-diode (Z20), the cathode of which diode is connected to the collector (K20) of the output stage transistor (T20) (Figures 2b and 2c).

8. Power output stage according to Claim 7, characterized in that the pnp transistor (T21) forming the transistor amplifier is constructed as a Darlington amplifier (Figs. 2b and 2c).

9. Power output stage according to one of Claims 1 to 8, characterized in that a resistor (R35) with a capacitor (C30) connected downstream is connected between the base and the collector (K30) of the output stage transistor (T35), in that the centre connection between the resistor (R35) and the capacitor (C30) is connected to the base of an npn transistor (T33), the collector of which is connected to the collector (K30) of the output stage transistor (T35) and the emitter of which is connected to the base of a further npn transistor (T34), in that the collector of the further npn transistor (T34) is connected to the collector (K30) of the output stage transistor (T35) and the emitter of the further npn transistor (T34) is connected, via a resistor (R36), to the base of the output stage transistor (T35).

10. Voltage limiting device for limiting the voltage across a terminal, carrying a positive potential, of a transistor circuit having a voltage divider (R41; R42) between the terminal (K40; K50) and earth and a Z-diode (Z40; Z50), which serves as a voltage reference element, is arranged in a current path between the terminal and earth and is operatively connected to a tap of the voltage divider, characterized in that the voltage limiting device additionally contains a transistor amplifier (T41, T42; T51, T52), the emitter-collector path of which amplifier is connected in series with the Z-diode (Z40; Z50).

11. Voltage limiting device according to Claim 10, characterized in that the anode of the Z-diode (Z50) is connected to earth via the base-emitter junction of an npn transistor (T53), the collector of the transistor (T53) being connected to the terminal (K50).

12. Voltage limiting device according to Claim 10 or 11, characterized in that the anode of the Z-diode (Z40; Z50) is connected to earth, and in that the transistor amplifier is an npn transistor (T41, T42; T51, T52), preferably designed as a Darlington transistor, the base of which is connected to the tap of the voltage divider (R41, R42; R51, R52), the collector of which is connected to the terminal (K40; K50) and the emitter of which is connected to the cathode of the Z-diode (Z40; Z50) (Figures 4 and 5).

13. Voltage limiting device according to Claim 12, characterized in that the Darlington transistor (T41, T42; T51, T52) has an input transistor (T41; T51) and an output transistor (T42; T52), preferably constructed as a Darlington transistor.

14. Voltage limiting device according to Claim 13, characterized in that an emitter series resistor (R43; R53) is connected in the emitter circuit of the input transistor (T41; T51) and a further resistor (R44; R54) is connected between the base and the emitter of the output transistor (T42; T52) and forms, together with the emitter series resistor (R43; R53), a further voltage divider (R43, R44; R53, R54).

## Revendications

1. Etage terminal de puissance à transistor avec un transistor d'étage terminal npn (T20, T35) et avec un dispositif de limitation de la tension pour limiter la tension au collecteur du transistor d'étage terminal (T20, T35), dispositif qui comprend un diviseur de tension (R21, R22) placé entre le collecteur et l'émetteur du transistor d'étage terminal (T20, T35) ainsi qu'une diode de Zener (Z20, Z30) servant d'élément de référence de la tension, qui est disposée sur un trajet de courant shuntant le collecteur-base du transistor d'étage terminal (T20, T35), et qui est en liaison active avec une prise du diviseur de tension (R21, R22), étage terminal de puissance, caractérisé en ce que le dispositif de limitation de la tension comprend en outre un amplificateur à transistor (T21 ; T31, T32), dont la section émetteur-collecteur est branchée en série avec la diode Z (Z20 ; Z30).

7

2. Etage terminal de puissance selon la revendication 1, caractérisé en ce que le transistor npn d'étage terminal (T20 ; T35/36) est un transistor Darlington (figures 2d et 3b).

3. Etage terminal de puissance selon la revendication 1 ou la revendication 2, caractérisé en ce que l'amplificateur de transistor est un transistor npn (T21), qui se raccorde avec sa base à la prise du diviseur de tension (R21, R22), avec son collecteur au collecteur du transistor d'étage terminal (T20) et avec son émetteur à la cathode de la diode Z (Z20), laquelle s'applique avec son anode sur la base du transistor d'étage terminal (T20) (figure 2a).

4. Etage terminal de puissance selon la revendication 3, caractérisé en ce que le transistor npn (T21) formant l'amplificateur de transistor, est réalisé sous la forme d'amplificateur Darlington (figures 2a et 3a).

5. Etage terminal de puissance selon la revendication 4, caractérisé en ce que l'amplificateur Darlington (T21) revêt la forme d'un amplificateur à deux étages constitué d'un transistor d'entrée (T31) et d'un transistor de sortie (T32).

6. Etage terminal de puissance selon la revendication 5, caractérisé en ce que, dans un circuit émetteur du transistor d'entrée (T31) est branché une prérésistance émetteur (R33) et entre la base et l'émetteur du transistor de sortie (T32) est branchée une autre résistance (R34) qui forme avec la prérésistance émetteur (R33) un autre diviseur de tension (R33, R34)(figure 3a).

7. Etage terminal de puissance selon la revendication 1 ou la revendication 2, caractérisé en ce que l'amplificateur à transistor est un transistor pnp (T21), qui est raccordé par sa base à la prise du diviseur de tension (R22, R21) avec son collecteur à la base (B20) du transistor terminal et par son émetteur à l'anode de la diode de Zener (Z20), qui par sa cathode s'applique au collecteur (K20) du transistor d'étage terminal (T20) (figures 2b et 2c).

8. Etage terminal de puissance selon la revendications 7, caractérisé en ce que le transistor pnp (T21) formant l'amplificateur de transistor est réalisé sous la forme d'un amplificateur Darlington (figures 2b et 2c).

9. Etage terminal de puissance selon une des revendications 1 à 8, caractérisé en ce que entre la base et le collecteur (K30) du transistor d'étage terminal (T35) est placée une résistance (R35) à la suite de laquelle est placé un compensateur (C30), en ce que le raccordement médian entre la résistance (R35) et le condensateur (C30) est en liaison avec la base d'un transistor npn (T33), qui avec son collecteur est relié au collecteur (K30) du transistor d'étage terminal (T35) et avec son émetteur à la base d'un autre transistor npn (T34), en ce que le collecteur de l'autre transistor npn (T34) est relié avec le collecteur (K30) du transistor d'étage terminal (T35) et l'émetteur de l'autre transistor npn (T34) est relié par l'intermédiaire d'une résistance (R36) à la base du transistor d'étage terminal (T35).

10. Dispositif de limitation de la tension pour limiter la tension sur une borne, mise à un potentiel positif, d'un circuit de transistor avec un diviseur de tension (R41 ; R42) placé entre la borne (K40 ; K50) et la masse, et une diode de Zener (Z40 ; Z50) servant d'élément de référence de tension, qui est disposée sur un trajet de courant entre la borne et la masse et qui est en liaison active avec une prise du diviseur de tension, dispositif caractérisé en ce que le dispositif de limitation de la tension comprend en outre un transistor (T41, T42 ; T51, T52), qui avec son trajet émetteur-collecteur est branché en série par rapport à la diode de Zener (Z40 ; Z50).

11. Dispositif de limitation de la tension selon la revendication 10, caractérisé en ce que l'anode de la diode de Zener (Z50) est reliée à la masse par l'intermédiaire du trajet base-émetteur d'un transistor npn (T53), tandis que le collecteur du transistor (T53) est raccordé à la borne (K50).

12. Dispositif de limitation de la tension selon la revendication 10 ou la revendication 11, caractérisé en ce que l'anode de la diode de Zener (Z40 ; Z50) est reliée à la masse et en ce que l'amplificateur de transistor est de préférence un transistor npn (T41, T42 ; T51, T52) réalisé sous la forme d'un transistor Darlington, qui est raccordé avec sa base à la prise du diviseur de tension (R41, R42 R51, R52), avec son collecteur à la borne (K40 ; K50) et avec son émetteur à la cathode de la diode de Zener (Z40 ; Z50) (figures 4 et 5).

**13.** Dispositif de limitation de la tension selon la revendication 12, caractérisé en ce que le transistor Darlington (T41, T42 ; T51, T52) a un transistor d'entrée (T41 ; T51) et un transistor de sortie (T42 ; T52) de préférence réalisé sous la forme d'un transistor Darlington.

**14.** Dispositif de limitation de la tension selon la revendication 13, caractérisé en ce que sur le circuit d'émetteur du transistor d'entrée (T41 ; T51) est branchée une résistance d'émetteur (R43 ; R53) et entre la base et l'émetteur du transistor de sortie (T42 ; T52) est branchée une autre résistance (R44 ; R54) qui conjointement avec la distance d'émetteur (R43 ; R53) forment un autre diviseur de tension (R43, R44 ; R53, R54).

*FIG.1*

*FIG.2a*

FIG. 2b

FIG. 2c

FIG. 2d

FIG. 3a

FIG. 3b

FIG. 4

FIG. 5

FIG.6